# EUROPEAN PATENT SPECIFICATION

(11) **EP 3 301 792 B1**
(45) Date of publication and mention of the grant of the patent: **04.11.2020**
(21) Application number: 17188059.4
(22) Date of filing: 28.08.2017
(51) Int. Cl.: H02K 11/20, G01R 33/02, G01R 33/028, H02K 7/18

(54) **METHOD AND MEASUREMENT SYSTEM FOR ANALYZING A TEMPORAL VARIATION OF A MAGNETIC FLUX PRODUCED BY A MAGNETIC FIELD PRODUCER AT A ROTOR OF A GENERATOR**
VERFAHREN UND MESSSYSTEM ZUR ANALYSE EINER DURCH EINEN MAGNETFELDERZEUGER AN EINEM GENERATORROTOR VERURSACHTEN ZEITLICHEN ABWEICHUNG EINES MAGNETISCHEN FLUSSES
PROCÉDÉ ET SYSTÈME DE MESURE POUR L'ANALYSE D'UNE VARIATION TEMPORELLE D'UN FLUX MAGNÉTIQUE PRODUIT PAR UN GÉNÉRATEUR DE CHAMP MAGNÉTIQUE AU NIVEAU D'UN ROTOR D'UN GÉNÉRATEUR

(30) Priority: 30.09.2016 DE 102016218966
(43) Date of publication of application: 04.04.2018
(73) Proprietor: Siemens Gamesa Renewable Energy A/S, 7330 Brande (DK)
(72) Inventor: Groendahl, Erik, 8653 Them (DK); Lemma, Edom, 7100 Jerlev, Vejle (DK)
(74) Representative: Aspacher, Karl-Georg

(56) References cited:
- EP-A1- 2 746 795
- US-B1- 6 466 009

## Description

### Field of invention

The present invention relates to the field of electric generators applicable in different types of machines, in particular in wind turbines. Specifically, the present invention relates to a measurement system for analyzing a temporal variation of a magnetic flux which is produced by a magnetic field producer at a movable rotor of a generator as well as a generator comprising such a measurement system. Further, the present invention relates to a wind turbine being equipped with such a generator. Further, the present invention relates to a method for analyzing a temporal variation of magnetic flux produced by a magnetic field producer arranged at a rotor of a generator by using a measurement system. Furthermore, the present invention relates to a method for exchanging a magnetic field producer of a generator.

### Art Background

Generators used in many applications have to be built with a high constructional precision. In operation, a rotor comprising the magnetic field producer moves relative to a stator and causes a time varying magnetic flux through a plurality of conductor coils of the stator. During lifetime of a generator it may be possible that the magnetic field producers may degrade or become prone to failures, such as a demagnetization. This means that the magnetic field producers degrade over the time or during use of the generator or they may become faulty magnetic field producers.

US6466009 discloses a flexible probe for detecting time-varying magnetic fields produced in an electric generator. The flexible probe is adapted to be disposed within an air gap formed between an iron stator and a rotatable rotor. An electrostatic shield layer is formed on a front face of the probe and a printed circuit forming at least one coil is printed on the back face. When the flexible probe is used for detecting time-varying magnetic fields, a voltage is induced in the coil when the coil is exposed to a time-varying magnetic field.

EP2746795 discloses a device for measuring a magnetic field in an air-gap between a stator and a rotor of an electric machine. The device comprises a probe to detect the magnetic field and generate a signal indicative thereof and a display unit for the signal. The probe includes a plurality of sensors.

There may be a need for detecting degraded or even faulty magnetic field producers of a generator.

### Summary of the Invention

This need may be met by the subject matter according to independent claim 1 and by the method according to independent claim 11. Advantageous embodiments of the present invention are described by the dependent claims.

According to a first aspect of the invention there is provided a measurement system for analyzing a temporal variation of a magnetic flux which is produced by a magnetic field producer arranged at a movable rotor of a generator. The measurement system comprises a sensor device comprising a printed circuit board, a coil arranged at the printed circuit board, and an attachment means arranged at the printed circuit board. The attachment means is configured for attaching the printed circuit board at a stator of the generator, such that the printed circuit board is located within an air gap of the generator. The measurement system further comprises an evaluation unit electrically coupled to the coil and adapted to measure an electrical quantity induced in the coil by a movement of the magnetic field producer and to compare the measured electrical quantity with a reference electrical quantity.

This aspect of the invention is based on the idea that as compared to a faultless magnetic field producer a degraded or faulty magnetic field producer cause a degraded magnetic field. By recognizing such a degraded magnetic field a degraded or faulty magnetic field producer can be identified.

If a faulty magnetic field producer is in use in a device, e.g. a generator, the magnetic field produced by the magnetic field producer may not be homogenous any more. This inhomogeneity could cause a loss of efficiency and a loss of performance of the generator, which losses could be overcome by identifying the degraded or faulty magnetic field producer and by replacing or exchanging with a faultless magnetic field producer. For this purpose and in accordance with an embodiment of the invention a measurement system can be used to detect or identify the degraded or faulty magnet field producer by using a sensor device which comprises means for measuring the magnetic flux, in particular the temporal variation of the magnetic flux. Many conventional machines, e.g. many conventional generators, may be equipped with such a measurement system. By arranging the printed circuit board in the air gap between the rotor and the stator of a generator a simple and easy attachment may be provided which does only cause minor or even no design changes at all. Therefore, it is easy and does not cost much time and effort to equip many conventional generators with such a measurement system.

The "measurement system" may be incorporated as an optional part of a conventional generator such that a usual generator can be used with or without this measurement system. By using the measurement system the normal operation of the device , e.g. a generator, equipped with the measurement system would not be influenced by the measurement system. In other words, the magnetic field produced by a generator would not be influenced by the measurement system and vice versa.

In this document the term "temporal variation" may particularly denote a variation over time. In particular, the temporal variation may be a temporal change of the magnetic field itself or a temporal change caused by a movement of a conductive element in the magnetic field. Further, the temporal variation may be a temporal course of the magnetic flux.

The term "magnetic field producer" may particularly denote any device or an element which is able to produce a magnetic field. This producer may be a magnet or a coil, wherein in case of a coil an electric current is passing through the coil. Further, the magnetic field producer may be a separately excited device, apparatus or only a coil. In particular, the magnetic field producer may be formed of more than one element, such that the magnetic field producer comprises at least two elements, which separately form magnetic field producers. In this case, one could say that the magnetic field producer according to the present invention comprises a plurality of magnetic field producers or a plurality of magnetic field producer elements.

Further, the term "generator" may particularly denote any type of electrical generator which is used to convert mechanical energy in electrical energy. The generator may be a synchronous generator or an asynchronous generator. A conventional generator is typically formed of a stator and a rotor, which both extend circumferentially around a rotational axis of the generator. Further, in between the stator and the rotor an air gap is formed which also extends circumferentially around the rotational axis. The stator comprises a plurality of coils and the rotor comprises a plurality of magnetic field producers. A preferred generator used in connection with the present invention and which is equipped with the measurement system may be a generator of the so called inner stator - outer rotor configuration. In this context an inner stator - outer rotor configuration may mean that at least a part of a rotor respectively its rotor support structure is located radially outwards from the stator and rotates around the stator assembly. Thereby, in operation, magnets, in particular permanent magnets, which are arranged at an inner surface of an outer rotor assembly ring of the rotor support structure cause a time varying magnetic flux at the location of the stator. In this respect it is mentioned that in other embodiments of the invention a generator of an outer stator - inner rotor configuration could also be equipped with the measurement system.

The term "coil" may particularly denote a wiring structure used for detecting electrical quantities induced within the wiring structure. During the operation of the generator the moving magnet field producer induces an electrical quantity into the coil, e.g. a voltage and/or a current. Consequently, a change in the magnetic flux can be observed with the coil by analyzing the observed electric quantity. For the sake of clarity, the coil is arranged at the printed circuit board which belongs to the measurement system. The coil is not a coil respectively a winding of the stator.

The term "attachment means" may particularly denote any type of mechanical structure or element or more than one element which is used to attach the printed circuit board to the generator which should be equipped with the measurement system. In particular, the attachment means attaches the printed circuit board at a stator of the generator. In an inner stator - outer rotor configuration, the printed circuit board is attached at an outer surface of the stator.

The attachment means are removably attachable to the stator. The attachment of the printed circuit board by the attachment means is done for example in such a manner that the printed circuit board is punctual attached to the stator. For this purpose, only a part of the printed circuit board comprises attachment means, such that not the entire printed circuit board is directly attached.

The attachment means are magnetically attachment means which will be described in a following part of this document.

The term "evaluation unit" may particularly denote any type of electrical unit which is able to analyze the electrical quantity induced in the coil. Further, the evaluation unit may be able to store and to hold the measured electrical quantity for further processing, which may include calculations based on the measured electrical quantity. Further, it may be possible to transmit the held and/or the measured electrical quantity to another device, e.g. a computer, for further analysis. Further, the evaluation unit may be able to perform a process which compares the measured electrical quantity with a reference electrical quantity. For this purpose, the reference electrical quantity may be stored in the evaluation unit. In particular, more than one reference electrical quantity may be stored in the evaluation unit. Also different reference electrical quantities may be stored.

The evaluation unit may be a microcontroller connected to the coil, a processor connected to the coil, or an external computer connected to the coil.

The evaluation unit may evaluate the electrical quantity by using a software or by using only logical functions. The evaluation unit may be used to measure and compare at least one electrical quantity with a reference electrical quantity. The evaluation unit may in particular receive more than one electrical quantity from the coil, such that a temporal variation of the magnetic flux at the coil can be analyzed. The signal of the electrical quantity received from the coil may be sampled in a continuous or quasi continuous manner. Digital or analog values may be processed. The evaluation unit may comprise a respective converter to transform analog in digital values or vice versa for further processing.

The term "electrical quantity" may particularly denote a voltage or a current which is induced within the coil attached at the printed circuit board and which may be measured at the coil by use of the evaluation unit. Because of the electromagnetically induction over time within the coil, also a change of the electrical quantity may be generated and may be transmitted via an electrical connection to the evaluation unit.

The term "reference electrical quantity" may particularly denote a pre-determined electrical quantity, e.g. a voltage or a current value. The pre-determined electrical quantity may be an expected electrical quantity based on a fully functional, faultless and non-degraded magnetic field producer. This reference electrical quantity may be stored in the evaluation unit, such that the unit may have all time access to this reference electrical quantity to be able to compare the measured electrical quantity with the stored reference electrical quantity.

According to an embodiment of the invention the electrical quantity is a temporal course of at least two electrical values. The two electrical values may be two voltage values or two current values. By receiving at least two electrical values a temporal variation of these values may be detected and analyzed. When two values are used a course over time can be analyzed by the evaluation unit. These two electrical values may be compared with respective reference electrical quantities by the evaluation unit. For this purpose, the reference electrical quantity may be a reference temporal course of two reference electrical values. This means that, the two electrical values are compared with two reference electrical values. Thereby, the measured temporal course may be compared with a pre-determined or an expected temporal course. All measured electrical quantities, i.e. all measured electrical values, may be stored in the evaluation unit.

According to a further exemplary embodiment of the invention the sensor device further comprises at least one further coil arranged at the printed circuit board. The further coil is also adapted to measure the variation of magnetic flux caused by the movement of the magnetic field producer. When using at least two coils for detecting the temporal variation it may be possible to detect the variation of the magnetic flux caused by more than one magnetic field producer. Therefore with the use of at least two coils at least two magnetic field producers may be analyzed.

The coil and the further coil may have the same size, such that each coil may be associated with a respective magnetic field producer at the rotor. In other embodiments, the coils have different sizes. For instance, one coil may be used to detect the temporal variation in one respective magnetic field producer and the other coil may be used to detect the temporal variation in more than one other magnetic field producers. Generally speaking, each coil may be associated with one magnetic field producer

According to a further exemplary embodiment of the invention the evaluation unit is further coupled to the at least one further coil. Further, the evaluation unit is further adapted to measure a further electrical quantity of the at least one further coil and to compare the further electrical quantity of the at least further coil with a respective reference electrical quantity. Descriptive speaking, the evaluation unit is coupled to each coil.

The evaluation unit may be electrically coupled to the coil(s) by coil terminals. According to this embodiment, the evaluation unit may compare the measured values of each coil associated to the respective magnetic field producer with reference value(s). Further, the evaluation unit may store the measured electrical quantities of each connected coil for further processing. In particular, the evaluation unit may store the measured electrical values of each coil (of the coil, of the one further coil and/or of more than the at least one further coil). Such an embodiment may allow for a simultaneous observation of the electrical quantities induced within all coils attached at the printed circuit board.

According to a the invention the attachment means comprises at least one magnet arranged at the printed circuit board. The printed circuit board is configured to be attachable at the stator of the generator by the magnet in such a manner that it is easy to attach and simultaneously easy to remove. For this reason, no design changes to a conventional generator have to be made. Further, the attachment means may comprise a plurality of magnets which are arranged at the printed circuit board. The attachment means may provide a safe and easy fixation of the measurement system at the stator of the generator, in particular at the outer surface of the stator (in case of an inner stator - outer rotor configuration).

The printed circuit board may be attachable in particular to the stack of the stator, wherein the stack may be comprised of a at least two isolated metal sheets. The magnets which may function as the attachment means may not or at least not significantly affect or deteriorate the magnetic field in the generator. This holds in particular true when these magnets are, as compared to permanent magnets representing the magnetic field producer, weak magnets which have a reminiscent magnetic flux density of about 1.2 T or less.

According to a further aspect of the invention there is provided an electrical generator comprising a stator and a rotor rotatably mounted at the stator in such a manner that it is rotatable around a rotational axis. The rotor comprises a plurality of magnetic field producers which are arranged circumferentially around the rotational axis and wherein in between the stator and the rotor there is formed an air gap. The air gap extends circumferentially around the rotational axis. Further the generator comprises a measurement system according to an exemplary embodiment described above, which is arranged in the air gap.

In accordance with the above described measurement system this aspect of the invention is based on the idea that as compared to a faultless magnetic field producer a degraded or faulty magnetic field producer of a generator cause a different and typically also degraded magnetic field. By recognizing such a different magnetic field a degraded or faulty magnetic field producer can be identified. As has already been mentioned above the measurement system can be attached to a conventional generator such that only minor or even no design changes may be necessary at the generator.

In this document the term "rotational axis" may particularly denote the axis of the generator around which the components of the rotor rotate. In this context it should be clear that in normal generator operation the stator comprises a stator winding, also called stator coil, which is used for "picking up" a time alternating magnetic flux and, in response thereto, for generating at least a portion of the overall output current of the generator. For this reason a plurality of stator segments are provided which are arranged around a rotational axis of the generator, wherein each stator segment comprises at least one conductor coil in which during normal operation of the electric generator magnetic induction takes place. Due to the conventional construction also the air gap is arranged such that it extends circumferentially, in particular in circular form, around the rotational axis and therefore is separating the rotor from the stator.

According to a further exemplary embodiment of the invention the rotor further comprises at least one further plurality of further magnetic field producers which are arranged circumferentially around the rotational axis, wherein in particular, the plurality of magnetic field producers are arranged in a first axial position and the further plurality of further magnetic field producers are arranged in a second axial position being different from the first axial position. Descriptive speaking, in addition to the magnetic field producers, which may be arranged at a first axial position of the rotational axis, further magnetic field producers are arranged at another (second) axial position of the rotational axis. Therefore, sufficient voltage and/or current may be induced into the coils of the stator.

According to a further exemplary embodiment of the invention one of the magnetic field producers and one of the further magnetic field producers are arranged in a row extending along an axial direction. In other words, the magnetic field producers arranged at the different axial positions may be arranged such that they adjacent to each other in a row wherein the row may be extending in an axial direction, in particular in the axial direction of the rotational axis. Further, all magnetic field producers at a different axial position, which extend circumferentially around the rotational axis, may be arranged in a row. Therefore, a homogenous magnetic field may be produced because of the specific arrangement of the magnetic field producers.

According to a further exemplary embodiment of the invention the coil is arranged at the same axial position as the one of the magnetic field producers and a further coil arranged at the printed circuit board is arranged at the same axial position as the one of the further magnetic field producers. The coils arranged at the printed circuit board may be arranged in a row such that every coil at the printed circuit board may be assigned to a respective magnetic field producer. In particular, the coils may be arranged along the axial direction of the rotational axis at the printed circuit board. The magnetic field producers may be also arranged in a row in the axial direction. According to this arrangement of the coils and the magnetic field producers a faulty magnetic field producer may be identified from the plurality of magnetic field producers. In particular, for each magnetic field producer the evaluation unit may measure the electrical quantity induced within the specific coil and may compare this measured electrical quantity with a reference electrical quantity. Furthermore, the number of coils and the number of further coils may be equal to the number of magnetic field producers and to the number of further magnetic field producers, respectively. Therefore, the row comprising the degraded or faulty magnetic field producer may be detected but also the respective magnetic field producer inside the row itself may be detected.

According to a further exemplary embodiment of the invention the magnetic field producers and/or the further magnetic field producers are permanent magnets. In other words, a self-excited generator comprising permanent magnets on the rotor is formed.

According to a further aspect of the invention there is provided a wind turbine comprising a wind rotor having at least two blades, a mechanical drive train connected to the wind rotor, and a generator according to an exemplary embodiment described above. The rotor is mechanically connected to the drive train.

In accordance with the above described measurement system and the above described generator, this aspect of the invention is based on the idea that as compared to faultless magnetic field producers degraded or faulty magnetic field producers of a generator in a wind turbine cause a different and typically also degraded magnetic field. By recognizing such a different magnetic field a degraded or faultless magnetic field producer can be identified. Therefore, degraded or faulty magnetic field producers inside the generator of a wind turbine can be easily detected. In this respect it is mentioned that in particular for maintenance reasons in wind turbine self-excited generators are employed having a rotor assembly with permanent magnets. For detecting a faulty or degraded permanent magnet in an easy and effective manner the measurement system according to the above description can be used.

According to a further aspect of the invention there is provided a method for analyzing a temporal variation of a magnetic flux which is produced by a magnetic field producer arranged at a movable rotor of a generator. The method comprises detecting the temporal variation by analyzing an electrical quantity induced by a movement of the magnetic field producer by means of a measurement system according to an exemplary embodiment described above.

According to a further exemplary embodiment of the invention the method further comprises associating the measured electrical quantity to a respective magnetic field producer out of a plurality of magnetic field producers which are arranged in a circumferential direction at a rotor of the generator. In the evaluation unit the number of magnetic field producers at the rotor may be stored. The evaluation unit may associate the respective magnetic field producer which is tested by the coil arranged at the printed circuit board. This association may be done such that the evaluation unit knows which of the magnetic field producers is a reference magnetic field producer being located at a predetermined angular position at the rotor. With the knowledge of this reference magnetic field producer for each angle of rotation a magnetic field producer out of the plurality of magnetic field producers can be identified.

If the rotor comprises a plurality of magnetic field producers and a further plurality of magnetic field producers which are arranged in a row the electrical quantity of each single row of magnetic field producers may be detected and the deviation from the reference electrical quantity may be determined. When using more than one coil at the printed circuit board each magnetic field producer inside one row may be assigned to each coil arranged in a row (at the printed circuit board). Because of this, each magnetic field producer inside one row may be tested and therefore, from each single magnetic field producer in one row the electrical quantity may be measured. When the magnetic field producers are passing the coil at the printed circuit board the evaluation unit knows which magnetic field producer is tested, such that the measured electrical quantity may be assigned to the respective magnetic field producer.

According to the invention the method further comprises comparing the measured electrical quantity with a reference electrical quantity and, if the measured electrical quantity differs from the reference electrical quantity identifying the respective magnetic field producer as faulty. Descriptive speaking, because of the assignment of the measured electrical quantity to each magnetic field producer, the faulty magnetic field producer may be identified. In particular, the row comprising the faulty magnetic field producer may be determined and more in particular, the specific magnetic field producer within one row can be identified. With the help of the stored data inside of the evaluation unit the evaluation unit may be able to compare the measured electrical quantity and, if the measured electrical quantity differs from the reference electrical quantity, the respective deviation may be an indicator for a faulty or degraded magnetic field producer and also for a degree of faultiness of the magnetic field producer. As a consequence, the evaluation unit may easily identify the faulty and/or degraded magnetic field producer(s). For this purpose, the evaluation unit may comprise an indicator to display for a user the magnetic field producer which has been detected as to be faulty or degraded.

According to a further aspect of the invention there is provided a method for exchanging a magnetic field producer of a generator. The method comprises performing a method to detect a temporal variation of magnetic flux according to an exemplary embodiment as described above. The method further comprises removing the magnetic field producer, which has been identified as to be faulty or degraded, from the rotor, and installing a faultless magnetic field producer at the rotor.

By identifying such a degraded magnetic field a degraded or faulty magnetic field producer can be identified and after the identification can be exchanged. It is mentioned, that also more than one faulty magnetic field producer may be identified. For this purpose, the faulty or degraded magnetic field producer(s) has respectively have to be identified according to an exemplary embodiment described above. After having been identified the faulty or degraded magnetic field producer will be removed. The removing may be done during maintenance work at the generator. It might be possible that only a single magnetic field producer is removed from the rotor. After removing the faulty (degraded) magnetic field producer it may be exchanged by a faultless magnetic field producer which is installed instead of the faulty magnetic field producer at the rotor. In particular the faultless magnetic field producer may be installed at the place of the removed faulty magnetic field producer at the rotor. After exchanging the faulty magnetic field producer a desired magnetic field produced by the magnetic field producer(s) of the rotor may be re-established. As a consequence, the generator will operate at is optimum efficiency and performance.

It has to be noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless other notified, in addition to any combination of features belonging to one type of subject matter also any combination between features relating to different subject matters, in particular between features of the method type claims and features of the apparatus type claims is considered as to be disclosed with this document.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawings

- Figure 1: shows a section of a generator having an inner stator - outer rotor configuration.
- Figure 2: shows a measurement system for detecting magnetic flux within an air gap of a generator.
- Figure 3: shows a top view of the measurement system.
- Figure 4: shows a section of a generator having an outer stator - inner rotor configuration.
- Figure 5: shows a further measurement system for detecting magnetic flux within an air gap of a generator.
- Figure 6: shows a wind turbine equipped with a generator according to an exemplary embodiment of the invention.

### Detailed Description

The illustration in the drawing is schematical. It is noted that in different Figures, similar or identical elements or features are provided with the same reference signs or with reference signs, which are different from the corresponding reference signs only within the first digit. In order to avoid unnecessary repetitions elements or features which have already been elucidated with respect to a previously described embodiment are not elucidated again at a later position of the description.

Further, spatially relative terms, such as "front" and "back", "above" and "below", "left" and "right", et cetera are used to describe an element's relationship with respect to another element(s) as illustrated in the Figures. Thus, the spatially relative terms may apply to orientations in use which differ from the orientation depicted in the Figures. Obviously, all such spatially relative terms refer to the orientation shown in the Figures only for ease of description and are not necessarily limiting as an apparatus according to an embodiment of the invention can assume orientations different than those illustrated in the Figures when in use.

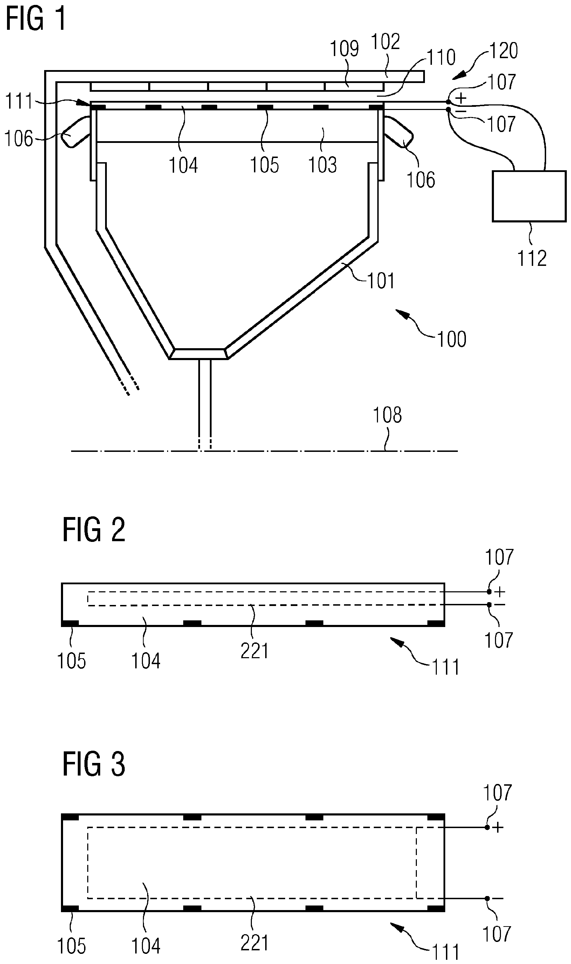

Figure 1 shows a generator 100 according to an exemplary embodiment of the invention. The generator comprises a stator 101 and a rotor 102, wherein both extend in a circumferential direction around a rotational axis 108. The rotor 102 and the stator 101 are separated by an air gap 110. In particular the air gap 110 is formed in between the inner circumference of the rotor 102 and the outer circumference of the stator 101. The stator 101 comprises a stator segment 103, stator end windings 106 and stator coils in which the rotor 102 causes a time varying magnetic flux. In this example the generator is a generator of the inner stator - outer rotor configuration, wherein at least the relevant functional elements of the rotor 102 are located outside from and rotate around the stator 101. The generator 100 further comprises a measurement system 120 with a sensor device 111 which comprises a printed circuit board 104.

At the printed circuit 104 board is attached a coil (not displayed in Figure 1) and an attachment means 105. The printed circuit board 104 is attached at the stator 101 of the generator 100 by means of the attachment means 105. As can be seen, the printed circuit board 104 is attached to the outer side, i.e. outer surface, of the stator 101, in particular the stator segment 103. The attachment means 105 are used to attach the printed circuit board 104 to the stator 101.

According to this embodiment the attachment means 105 are permanent magnets. As can be seen in Figure 1, at the printed circuit board 104 more than one magnet 105 is attached, in particular six magnets 105, by which the printed circuit board 104 is attached to the stator 101.

The sensor device 111 detects a temporal variation of the magnetic flux produced by the movement of a magnetic field producer 109 which is attached at the rotor 102. The detected temporal variation of the magnetic flux is analyzed by the evaluation unit 112 which is electrically coupled to the coil 221 by coil terminals 107. For this purpose, the evaluation unit 112 is coupled to the coil terminals 107 by an electrical connection.

According to the embodiment described here the generator 100 comprises a plurality of magnetic field producers 109, which are arranged circumferentially around the rotational axis 108. Further the generator 100 comprises four further pluralities of magnetic field producers 109 which are arranged circumferentially around the rotational axis 108. All pluralities of magnetic field producers are arranged at a specific axial position, such that there are five different axial positions, each of which is assigned to one group respectively one plurality of magnetic field producers. In other words, according to this embodiment the rotor 102 comprises respectively five magnetic field producers 109 which are arranged in a row, wherein each magnetic field producer 109 is arranged at a different axial position at the rotational axis 108.

Figure 2 shows an exemplary embodiment of the sensor device 111. As can be seen from Figure 2, the sensor device 111 comprises the printed circuit board 104, the coil 221, the coil terminals 107 and the attachment means 105. The coil terminals 107 extend out from the printed circuit board 104 to be able to be connected to the evaluation unit 112 of the measurement system 120.

Figure 3 shows a top view of the sensor device 111 of Figure 2. The coil 221 has a rectangular shape for forming a loop. Other shapes as a circular or an oval shape may also be possible. The printed circuit board 104 comprises eight attachment means 105. The attachment means 105 are permanent magnets. The attachment means 105 are arranged at the longitudinal edges of the printed circuit board 104. However, the attachment means could also be arranged at the middle of the printed circuit board or they can be arranged in symmetrical or in unsymmetrical rows along the axial direction of the printed circuit board.

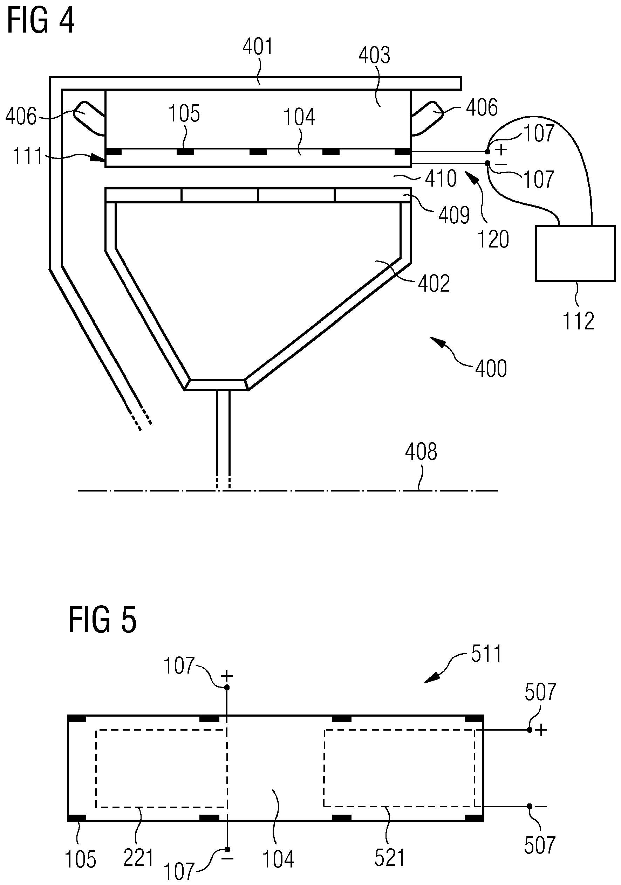

Figure 4 shows another exemplary embodiment of a generator 400 equipped with the sensor device 111. This type of generator comprises or is built up with a so called inner rotor - outer stator configuration. The stator 401 of this generator configuration also comprises a stator segment 403 and stator end windings 406. The rotor 402 according to this embodiment comprises magnetic field producers 409. As can be seen from Figure 4, the rotor 402 comprises four magnetic field producers 409.

The stator 401 and the rotor 402 extend circumferentially around a rotational axis 408. At the stator 401 the sensor device 111 is attached. The sensor device 111 may be of the same type as the sensor device 111 described in Figure 1. In accordance with the embodiment shown in Figure 1 the evaluation unit 112 is electrically connected to a coil terminal 107, such that the sensor device 111 and the evaluation unit 112 form a measurement system 120 for detecting a temporal variation of magnetic flux induced by the movement of magnetic field producers 409 of the rotor 402. By means of a proper analysis of the temporal variation faulty or degraded magnetic field producers 409 can be identified.

Figure 5 shows a further exemplary embodiment of the sensor device 511. The sensor device 511 comprises a printed circuit board 104, wherein at the printed circuit board 104 there is attached a further coil 521. The further coil 521 comprises further coil terminals 507 to be connected to the evaluation unit 112. The evaluation unit 112 can be coupled to the coil 221 and to the further coil 521, such that, in addition the electrical quantity of the coil 221, the evaluation unit 112 is adapted to measure a further electrical quantity of the at least one further coil 521 . Therefore, the evaluation unit 112 is adapted also to compare the further electrical quantity of the at least one further coil 521 with a further respective reference quantity. However, it is mentioned that at the printed circuit board 104 also more than the coil and the further coil can be attached. In particular three, four, or even more coils can be attached at the printed circuit board 104. The number of coils attached at the printed circuit board 104 should in particular be equal to the number of magnetic field producers 409 which are arranged in a row in an axial direction at the rotor.

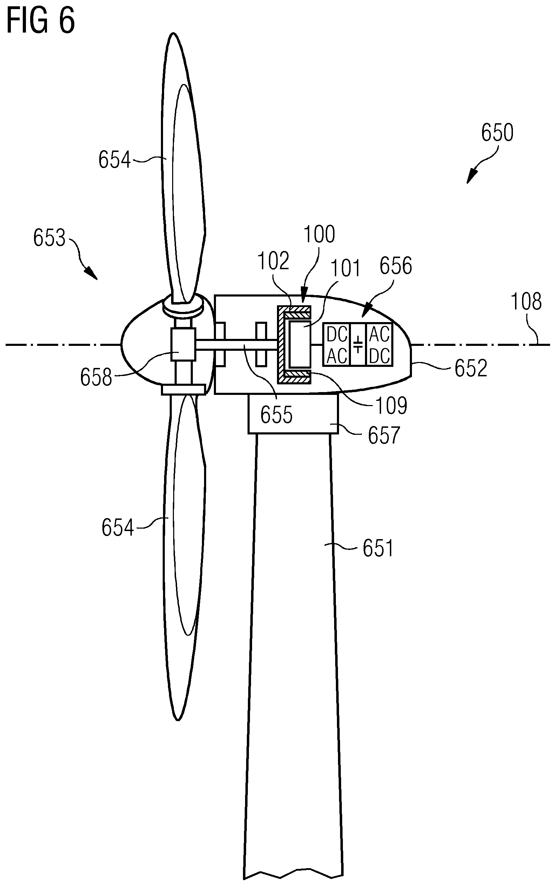

Figure 6 shows a wind turbine 650 according to an exemplary embodiment of the invention. The wind turbine 650 comprises a tower 651 which is mounted on a non-depicted fundament. On top of the tower 651 there is arranged a nacelle 652. In between the tower 651 and the nacelle 652 there is provided a yaw angle adjustment device 657, which is capable of rotating the nacelle 652 around a not depicted vertical axis, which is aligned with the longitudinal extension of the tower 651. By controlling the yaw angle adjustment device 657 in an appropriate manner it can be made sure that during a normal operation of the wind turbine 650 the nacelle 652 is always properly aligned with the current wind direction. The wind turbine 650 further comprises a wind rotor 653 having three blades 654. In the perspective of Figure 6 only two blades 654 are visible. The wind rotor 653 is rotatable around a rotational axis 108. The blades 654, which are mounted at a hub 658, extend radially with respect to the rotational axis 108. The rotational axis 108 is identic with a center axis of the stator 102.

At the nacelle 652 there is provided an electric generator 100. In accordance with basic principles of electrical engineering the electric generator 100 comprises a stator 101 and a rotor 102. As can be seen from Figure 6, the electric generator 100 is located between a front end of the nacelle 652 and the hub 658. The wind rotor 653 is rotationally coupled with the rotor 101 by means of a drive train 655.

According to the embodiment described here the electric generator 100 is realized with a so called inner stator - outer rotor configuration. Permanent magnets acting as magnetic field producers being attached to the rotor 102 travel around the stator 101. In between the stator 101, which comprises coils or windings for picking up a time alternating magnetic flux, and the permanent magnets, there is formed an air gap. Further, the wind turbine 650 is equipped with a measurement system for detecting temporal variation of magnetic flux which is produced by the permanent magnet(s) arranged at the rotor 102.

It is further mentioned that the wind turbine 650 is a so called direct drive wind turbine wherein between the wind rotor 653 and the rotor 102 at the generator 100 there is not provided a gear box. However, it is mentioned that the electric generator 100 could also be driven indirectly via a gear box, which may be used to convert the number of revolutions of the wind rotor 653 typically into a higher number of revolutions of the rotor 102.

In order to provide an AC power signal being matched with a utility grid the electric output of the stator 101 is electrically connected to a power converter 656 (e.g. by means of a three phase electric cable assembly).

It should be noted that the term "comprising" does not exclude other elements or steps and the use of articles "a" or "an" does not exclude a plurality. Also elements described in association with different embodiments may be combined. It should also be noted that reference signs in the claims should not be construed as limiting the scope of the claims.

## Claims

1. A measurement system for analyzing a temporal variation of a magnetic flux which is produced by a magnetic field producer (109) arranged at a movable rotor (102) of a generator (100), the measurement system comprising:
a sensor device (111) comprising
a printed circuit board (104);
a coil (221) arranged at the printed circuit board (104); and
an attachment means (105) comprising at least one magnet arranged at the printed circuit board (104) and configured for removably attaching the printed circuit board (104) at a stator (101) of the generator (100) such that the printed circuit board (104) is located within an air gap (110) of the generator (100);
an evaluation unit (112) electrically coupled to the coil (221) and adapted to measure an electrical quantity induced in the coil (221) by a movement of the magnetic field producer (109) and to compare the measured electrical quantity with a reference electrical quantity and,
if the measured electrical quantity differs from the reference electrical quantity, identify the respective magnetic field producer as faulty.

2. The measurement system according to claim 1,
wherein
the electrical quantity is a temporal course of at least two electrical values.

3. The measurement system according to one of the claims 1 to 2, wherein the sensor device (111) further comprises at least one further coil (521) arranged at the printed circuit board (104).

4. The measurement system according to one of the claims 1 to 3, wherein
the evaluation unit (112) is further coupled to the at least one further coil (521), and wherein
the evaluation unit (112) is further adapted
to measure a further electrical quantity of the at least one further coil (521) and
to compare the further electrical quantity of the at least further coil (521) with a respective reference electrical quantity.

5. An electrical generator (100) comprising
a stator (101);
a rotor (102) rotatably mounted at the stator (101) in such a manner that it is rotatable around a rotational axis (108),
wherein the rotor (102) comprises a plurality of magnetic field producers (109) which are arranged circumferentially around the rotational axis (108) and
wherein in between the stator (101) and the rotor (102) there is formed an air gap (110),
wherein the air gap (110) extends circumferentially around the rotational axis (108), and
a measurement system according to any one of the preceding claims, which is arranged in the air gap (110).

6. The generator (100) according to claim 5, wherein
the rotor (102) further comprises
at least one further plurality of further magnetic field producers (109) which are arranged circumferentially around the rotational axis (108),
wherein in particular the plurality of magnetic field producers (109) are arranged in a first axial position and the further plurality of further magnetic field producers are arranged in a second axial position being different from the first axial position.

7. The generator (100) according to claim 6, wherein
one of the magnetic field producers (109) and one of the further magnetic field producers are arranged in a row extending along an axial direction.

8. The generator (100) according to claim 7,
wherein
the coil (221) is arranged at the same axial position as the one of the magnetic field producers (109) and a further coil (521) arranged at the printed circuit board (104) is arranged at the same axial position as the one of the further magnetic field producers.

9. The generator (100) according to any one of the claims 5 to 8, wherein
the magnetic field producers (109) and/or the further magnetic field producers are permanent magnets.

10. A wind turbine (650) comprising
a wind rotor (653) having at least two blades (654);
a mechanical drive train (655) connected to the wind rotor (653); and
a generator (100) according to any one of the claims 6 to 9, wherein the rotor (102) is mechanically connected to the drive train (655).

11. A method for analyzing a temporal variation of a magnetic flux by a measurement system according to one of the claims 1-4, the magnetic flux is produced by a magnetic field producer arranged at a movable rotor (102) of a generator (100), the method comprising:
detecting the temporal variation;
by analyzing an electrical quantity induced by a movement of the magnetic field producer by means of a measurement system according to any one of the claims 1 to 4,
comparing the measured electrical quantity with a reference electrical quantity and, if the measured electrical quantity differs from the reference electrical quantity
identifying the respective magnetic field producer as faulty.

12. The method according to claim 11, further comprising
associating the measured electrical quantity to a respective magnetic field producer (109) out of a plurality of magnetic field producers (109) which are arranged in a circumferential direction at a rotor (102) of the generator (100) .

13. A method for exchanging a magnetic field producer of a generator (100), the method comprising
performing a method according to claim 11 or 12;
removing the magnetic field producer, which has been identified as to be faulty or degraded, from the rotor (102); and
installing a faultless magnetic field producer at the rotor (102).

## Patentansprüche

1. Messsystem zum Analysieren einer zeitlichen Schwankung eines magnetischen Flusses, der von einem Magnetfelderzeuger (109) erzeugt wird, welcher an einem beweglichen Rotor (102) eines Generators (100) angeordnet ist, wobei das Messsystem Folgendes umfasst:
eine Sensorvorrichtung (111), die Folgendes umfasst:
eine Leiterplatte (104),
eine Spule (221), die an der Leiterplatte (104) angeordnet ist, und
ein Befestigungsmittel (105), das mindestens einen Magneten umfasst, der an der Leiterplatte (104) angeordnet ist, und zum derartigen abnehmbaren Anbringen der Leiterplatte (104) an einem Stator (101) des Generators (100) konfiguriert ist, dass die Leiterplatte (104) in einem Luftspalt (110) des Generators (100) liegt,
eine Auswerteinheit (112), die elektrisch mit der Spule (221) gekoppelt und so ausgelegt ist, dass sie
eine elektrische Größe misst, die durch eine Bewegung des Magnetfelderzeugers (109) in der Spule (221) induziert wird, und
die gemessene elektrische Größe mit einer elektrischen Bezugsgröße vergleicht und,
wenn sich die gemessene elektrische Größe von der elektrischen Bezugsgröße unterscheidet, erkennt, dass der jeweilige Magnetfelderzeuger defekt ist.

2. Messsystem nach Anspruch 1, wobei
es sich bei der elektrischen Größe um einen zeitlichen Verlauf von mindestens zwei elektrischen Werten handelt.

3. Messsystem nach einem der Ansprüche 1 und 2, wobei die Sensorvorrichtung (111) ferner mindestens eine weitere Spule (521) umfasst, die an der Leiterplatte (104) angeordnet ist.

4. Messsystem nach einem der Ansprüche 1 bis 3, wobei
die Auswerteinheit (112) ferner mit der mindestens einen weiteren Spule (521) gekoppelt ist und wobei
die Auswerteinheit (112) ferner so ausgelegt ist, dass sie eine weitere elektrische Größe der mindestens einen weiteren Spule (521) misst und
die weitere elektrische Größe der mindestens einen weiteren Spule (521) mit einer jeweiligen elektrischen Bezugsgröße vergleicht.

5. Elektrischer Generator (100), der Folgendes umfasst:
einen Stator (101),
einen Rotor (102), der drehbar so an den Stator (101) montiert ist, dass er um eine Rotationsachse (108) drehbar ist,
wobei der Rotor (102) eine Vielzahl Magnetfelderzeuger (109) umfasst, die in Umfangsrichtung um die Rotationsachse (108) herum angeordnet sind, und
wobei zwischen dem Stator (101) und dem Rotor (102) ein Luftspalt (110) gebildet ist,
wobei der Luftspalt (110) in Umfangsrichtung um die Rotationsachse (108) herum verläuft, und
ein Messsystem nach einem der vorhergehenden Ansprüche, das in dem Luftspalt (110) angeordnet ist.

6. Generator (100) nach Anspruch 5, wobei
der Rotor (102) ferner Folgendes umfasst:
mindestens eine weitere Vielzahl weiterer Magnetfelderzeuger (109), die in Umfangsrichtung um die Rotationsachse (108) herum angeordnet sind,
wobei insbesondere die Vielzahl Magnetfelderzeuger (109) in einer ersten Axialposition und die weitere Vielzahl weiterer Magnetfelderzeuger in einer zweiten Axialposition angeordnet sind, die sich von der ersten Axialposition unterscheidet.

7. Generator (100) nach Anspruch 6, wobei
einer der Magnetfelderzeuger (109) und einer der weiteren Magnetfelderzeuger in einer Reihe angeordnet sind, die in einer axialen Richtung verläuft.

8. Generator (100) nach Anspruch 7, wobei
die Spule (221) in der gleichen Axialposition angeordnet ist wie einer der Magnetfelderzeuger (109) und eine an der Leiterplatte (104) angeordnete weitere Spule (521) in der gleichen Axialposition angeordnet ist wie der eine der weiteren Magnetfelderzeuger.

9. Generator (100) nach einem der Ansprüche 5 bis 8, wobei es sich bei den Magnetfelderzeugern (109) und/oder den weiteren Magnetfelderzeugern um Permanentmagneten handelt.

10. Windenergieanlage (650), die Folgendes umfasst:
einen Windrotor (653) mit mindestens zwei Rotorblättern (654),
einen mechanischen Antriebsstrang (655) der mit dem Windrotor (653) verbunden ist, und
einen Generator (100) nach einem der Ansprüche 6 bis 9, wobei der Rotor (102) mechanisch mit dem Antriebsstrang (655) verbunden ist.

11. Verfahren zum Analysieren einer zeitlichen Schwankung eines magnetischen Flusses mit einem Messsystem nach einem der Ansprüche 1 bis 4, wobei der magnetische Fluss von einem Magnetfelderzeuger erzeugt wird, der an einem beweglichen Rotor (102) eines Generators (100) angeordnet ist, wobei das Verfahren Folgendes umfasst:
Erfassen der zeitlichen Schwankung,
Analysieren einer elektrischen Größe, die durch eine Bewegung des Magnetfelderzeugers induziert wird, mithilfe eines Messsystems nach einem der Ansprüche 1 bis 4,
Vergleichen der gemessenen elektrischen Größe mit einer elektrischen Bezugsgröße und,
wenn sich die gemessene elektrische Größe von der elektrischen Bezugsgröße unterscheidet, Erkennen, dass der jeweilige Magnetfelderzeuger defekt ist.

12. Verfahren nach Anspruch 11, das ferner Folgendes umfasst:
Verknüpfen der gemessenen elektrischen Größe mit einem jeweiligen Magnetfelderzeuger (109) aus einer Vielzahl Magnetfelderzeuger (109), die in Umfangsrichtung an einem Rotor (102) des Generators (100) angeordnet sind.

13. Verfahren zum Austauschen eines Magnetfelderzeugers eines Generators (100), das Folgendes umfasst:
Ausführen eines Verfahrens nach Anspruch 11 oder 12,
Abnehmen des Magnetfelderzeugers, bei dem erkannt wurde, dass er defekt oder fehlerhaft ist, vom Rotor (102) und
Installieren eines intakten Magnetfelderzeugers am Rotor (102) .

## Revendications

1. Système de mesure pour analyser une variation temporelle d'un flux magnétique qui est produit par un élément de production de champ magnétique (109) agencé sur un rotor mobile (102) d'un générateur (100), le système de mesure comprenant :
un dispositif capteur (111) comprenant
une carte de circuit imprimé (104) ;
une bobine (221) agencée sur la carte de circuit imprimé (104) ; et
un moyen de fixation (105) comprenant au moins un aimant agencé sur la carte de circuit imprimé (104) et configuré pour fixer de manière amovible la carte de circuit imprimé (104) sur un stator (101) du générateur (100) de sorte que la carte de circuit imprimé (104) est située à l'intérieur d'un entrefer (110) du générateur (100) ;
une unité d'évaluation (112) couplée électriquement à la bobine (221) et conçue pour
mesurer une grandeur électrique induite dans la bobine (221) par un mouvement de l'élément de production de champ magnétique (109) et pour
comparer la grandeur électrique mesurée avec une grandeur électrique de référence et,
si la grandeur électrique mesurée diffère de la grandeur électrique de référence, identifier l'élément de production de champ magnétique respectif comme défectueux.

2. Système de mesure selon la revendication 1,
dans lequel
la grandeur électrique est une évolution temporelle d'au moins deux valeurs électriques.

3. Système de mesure selon l'une des revendications 1 à 2, dans lequel le dispositif capteur (111) comprend en outre au moins une bobine supplémentaire (521) agencée sur la carte de circuit imprimé (104).

4. Système de mesure selon l'une des revendications 1 à 3,
dans lequel
l'unité d'évaluation (112) est en outre couplée avec l'au moins une bobine supplémentaire (521), et dans lequel l'unité d'évaluation (112) est en outre conçue
pour mesurer une grandeur électrique supplémentaire de l'au moins une bobine supplémentaire (521) et
pour comparer la grandeur électrique supplémentaire de l'au moins une bobine supplémentaire (521) avec une grandeur électrique de référence respective.

5. Générateur électrique (100) comprenant
un stator (101) ;
un rotor (102) monté de manière rotative sur le stator (101) d'une manière telle qu'il est apte à tourner autour d'un axe de rotation (108),
dans lequel le rotor (102) comprend une pluralité d'éléments de production de champ magnétique (109) qui sont agencés de manière circonférentielle autour de l'axe de rotation (108) et dans lequel, entre le stator (101) et le rotor (102), est formé un entrefer (110),
dans lequel l'entrefer (110) s'étend de manière circonférentielle autour de l'axe de rotation (108), et
un système de mesure selon l'une quelconque des revendications précédentes, qui est agencé dans l'entrefer (110) .

6. Générateur (100) selon la revendication 5, dans lequel le rotor (102) comprend en outre
au moins une pluralité supplémentaire d'éléments de production de champ magnétique supplémentaires (109) qui sont agencés de manière circonférentielle autour de l'axe de rotation (108),
dans lequel, en particulier, la pluralité d'éléments de production de champ magnétique (109) sont agencés dans une première position axiale et la pluralité supplémentaire d'éléments de production de champ magnétique supplémentaires sont agencés dans une seconde position axiale qui est différente de la première position axiale.

7. Générateur (100) selon la revendication 6, dans lequel l'un des éléments de production de champ magnétique (109) et l'un des éléments de production de champ magnétique supplémentaires sont agencés en une rangée s'étendant le long d'une direction axiale.

8. Générateur (100) selon la revendication 7,
dans lequel
la bobine (221) est agencée à la même position axiale que ledit l'un des éléments de production de champ magnétique (109) et une bobine supplémentaire (521) agencée sur la carte de circuit imprimé (104) est agencée à la même position axiale que ledit l'un des éléments de production de champ magnétique supplémentaires.

9. Générateur (100) selon l'une quelconque des revendications 5 à 8, dans lequel
les éléments de production de champ magnétique (109) et/ou les éléments de production de champ magnétique supplémentaires sont des aimants permanents.

10. Éolienne (650) comprenant
un rotor éolien (653) ayant au moins deux pales (654) ;
une chaîne cinématique mécanique (655) raccordée au rotor éolien (653) ; et
un générateur (100) selon l'une quelconque des revendications 6 à 9, dans lequel le rotor (102) est mécaniquement raccordé à la chaîne cinématique (655).

11. Procédé pour analyser une variation temporelle d'un flux magnétique par un système de mesure selon l'une des revendications 1 à 4, le flux magnétique est produit par un élément de production de champ magnétique agencé sur un rotor mobile (102) d'un générateur (100), le procédé comprenant :
la détection de la variation temporelle ;
par l'analyse d'une grandeur électrique induite par un mouvement de l'élément de production de champ magnétique au moyen d'un système de mesure selon l'une quelconque des revendications 1 à 4,
la comparaison de la grandeur électrique mesurée avec une grandeur électrique de référence et, si la grandeur électrique mesurée diffère de la grandeur électrique de référence
l'identification de l'élément de production de champ magnétique respectif comme défectueux.

12. Procédé selon la revendication 11, comprenant en outre
l'association de la grandeur électrique mesurée à un élément de production de champ magnétique respectif (109) parmi une pluralité d'éléments de production de champ magnétique (109) qui sont agencés dans une direction circonférentielle sur un rotor (102) du générateur (100).

13. Procédé pour échanger un élément de production de champ magnétique d'un générateur (100), le procédé comprenant
la réalisation d'un procédé selon la revendication 11 ou 12 ;
le retrait de l'élément de production de champ magnétique, qui a été identifié comme étant défectueux ou dégradé, à partir du rotor (102) ; et
l'installation d'un élément de production de champ magnétique sans défaut sur le rotor (102).
